# EUROPEAN PATENT APPLICATION

(11) **EP 4 725 982 A1**
(43) Date of publication of application: **15.04.2026**
(21) Application number: 25205944.9
(22) Date of filing: 01.10.2025
(51) Int. Cl.: C08J 9/32, C08K 7/22, C09J 5/08

(54) **METHOD OF PRODUCING STRUCTURE, METHOD OF PRODUCING INTERIOR COMPONENT, AND METHOD OF PRODUCING ELECTRONIC DEVICE**

(30) Priority: 09.10.2024 JP 2024177419
(71) Applicant: Alps Alpine Co., Ltd., Ota-ku, Tokyo 145-8501 (JP)
(72) Inventor: Watanabe, Atsuro, Iwaki-city Fukushima (JP)
(74) Representative: Schmitt-Nilson Schraud Waibel Wohlfrom Patentanwälte Partnerschaft mbB

(57) **Abstract**

There is provided a method of producing a structure including a substrate and a resin foam layer bonded to the substrate. The method includes: coating the substrate with a mixture including an ultraviolet curable adhesive and thermally expandable microspheres, the ultraviolet curable adhesive including a photopolymerization initiator and an adhesive resin component; and irradiating the mixture with ultraviolet rays to polymerize the adhesive resin component and expand the thermally expandable microspheres, thereby forming the resin foam layer. The resin foam layer is bonded to the substrate with an adhesive force of the adhesive resin component.

## Description

This patent application is based on and claims priority to Japanese Patent Application No. 2024-177419 filed on October 9, 2024.

The present disclosure relates to a method of producing a structure including a resin foam layer that exhibits excellent adhesion to a substrate and can generate air cells within a short period, a method of producing an interior component using the method of producing the structure, and a method of producing an electronic device using the method of producing the structure.

Japanese Patent No. 7280986 and JP 2023-137382A describe inventions relating to production methods for articles. According to the invention described in Japanese Patent No. 7280986, a foamable adhesive sheet is disposed between a first member and a second member. The foamable adhesive sheet includes an adhesive composition including a thermoset resin and a blowing agent. The blowing agent is composed of thermally expandable microspheres. In each thermally expandable microsphere, a thermal expansion agent, such as hydrocarbon or the like, is encapsulated in a shell formed of a resin. The foamable adhesive sheet is heated to proceed with a curing reaction of the thermoset resin to improve adhesive strength, thereby bonding the two members with the foamable adhesive sheet, as well as softening the shells of the thermally expandable microspheres to expand the thermal expansion agent in the shells, thereby transforming the foamable adhesive sheet into a foam layer.

An adhesive member is also disposed between a first member and second member in the production method for the article described in JP 2023-137382A. The adhesive member includes at least a cured adhesive layer. The cured adhesive layer is a foam layer including a foamed and cured product including a curable adhesive and a blowing agent. As an example of the blowing agent, thermally expandable microspheres are listed. As examples of the curable adhesive, a thermoset adhesive and a photocurable adhesive are listed.

The present disclosure relates to a method of producing a structure and an interior component according to the appended claims. Embodiments are disclosed in the dependent claims. According to one aspect of the present disclosure, a method of producing a structure including a substrate and a resin foam layer bonded to the substrate is a method that includes:
(A) coating the substrate with a mixture including an ultraviolet curable adhesive and thermally expandable microspheres, the ultraviolet curable adhesive including a photopolymerization initiator and an adhesive resin component; and
(B) irradiating the mixture with ultraviolet rays to polymerize the adhesive resin component and expand the thermally expandable microspheres, thereby forming the resin foam layer,
wherein the resin foam layer is bonded to the substrate with an adhesive force of the adhesive resin component.

Objects and further features of the present disclosure will be apparent from the following detailed description when read in conjunction with the accompanying drawings, in which:
Figs. 1A to 1D are explanatory diagrams illustrating an embodiment of the method of producing the structure of the present disclosure;
Fig. 2 is a perspective view illustrating an embodiment of an interior component produced by the method of the present disclosure and used in an automobile or the like;
Fig. 3 is a cross-sectional view illustrating an embodiment of an electronic device produced by the method of the present disclosure;
Fig. 4 is a graph illustrating a bonding force between the resin foam layer and the substrate produced by the method of the present disclosure; and
Figs. 5A to 5B are explanatory diagrams illustrating a method of measuring the bonding force illustrated in Fig. 4.

In both of the production methods for the articles described in Japanese Patent No. 7280986 and JP 2023-137382A, the adhesive layer disposed between the first member and the second member is externally heated to soften the shells of the thermally expandable microspheres in the adhesive member, thereby expanding the thermal expansion agent in the shells. However, it takes a long time to expand the thermally expandable microspheres in the above production methods. The reason for this is considered to be that the heat externally applied to the adhesive layer is taken away by the adhesive composition, and is not readily transferred to the thermally expandable microspheres dispersed inside the adhesive layer so that it takes a long time to reach the temperature at which the thermally expandable microspheres expand.

Since the adhesive layer needs to be heated for a long time until the thermally expandable microspheres sufficiently expand, the adhesive composition may be overheated, and may decrease in adhesive strength due to deterioration of the adhesive composition or the like.

The present disclosure aims to address the above described problem in the related art, and aims to provide: a method of producing a structure, in which an adhesive resin component in an adhesive is polymerized by ultraviolet irradiation, and thermally expandable microspheres expand with the heat generated by the polymerization reaction so that a resin foam layer can be formed within a short period; a method of producing an interior component using the method of producing the structure; and a method of producing an electronic device using the method of producing the structure.

According to the method of producing the structure of the present disclosure, the step (A) preferably includes coating of the substrate with the mixture at a thickness equal to or less than a curing depth of the ultraviolet curable adhesive when a recommended integral dose of ultraviolet energy is applied.

In the method of producing the structure of the present disclosure, the curing depth is preferably greater than 5 mm, and more preferably 5.1 mm or greater and 10.5 mm or less.

In the method of producing the structure of the present disclosure, the mixture preferably includes the thermally expandable microspheres in an amount of 50 parts by mass or less, and more preferably 0.1 parts by mass or greater and 50 parts by mass or less, relative to 100 parts by mass of the ultraviolet curable adhesive.

According to an aspect, in the method of producing the structure of the present disclosure, the step (A) includes accommodating of the substrate and the mixture in a cavity of a mold, the cavity having an internal height greater than a total thickness of the substrate and the mixture, and the step (B) includes irradiating of the mixture with ultraviolet rays passing through the mold.

A method of producing an interior component of the present disclosure includes forming of a cushion layer with the resin foam layer using the method of producing the structure of the present disclosure.

A method of producing an electronic device of the present disclosure includes using of a printed circuit board on which an electronic component is mounted as a substrate, and forming of a cover layer covering the electronic component with the resin foam layer using the method of producing the structure of the present disclosure.

In the method of producing the structure of the present disclosure, the mixture of the ultraviolet curable adhesive and the thermally expandable microspheres is irradiated with ultraviolet rays to polymerize the adhesive resin component included in the ultraviolet curable adhesive, and the thermally expandable microspheres are expanded by the heat generated in the mixture by the polymerization reaction, thereby forming a resin foam layer. Since the heat generated inside the mixture is used, the thermally expandable microspheres can expand within a short period. In addition, since it is not necessary to externally heat the mixture at a high temperature, a strong adhesive force of the resin foam layer to the substrate is exhibited without deteriorating the adhesive resin component.

In the method of the present disclosure, the volumetric expansion ratio of the adhesive can be adjusted by adjusting the amount of the thermally expandable microsphere added to the ultraviolet curable adhesive, and therefore a cushion layer of an interior component of an automobile or the like can be produced by setting the volumetric expansion ratio high, and a cover layer that is the resin foam layer and covers an electronic component can be produced by setting the volumetric expansion ratio relatively low.

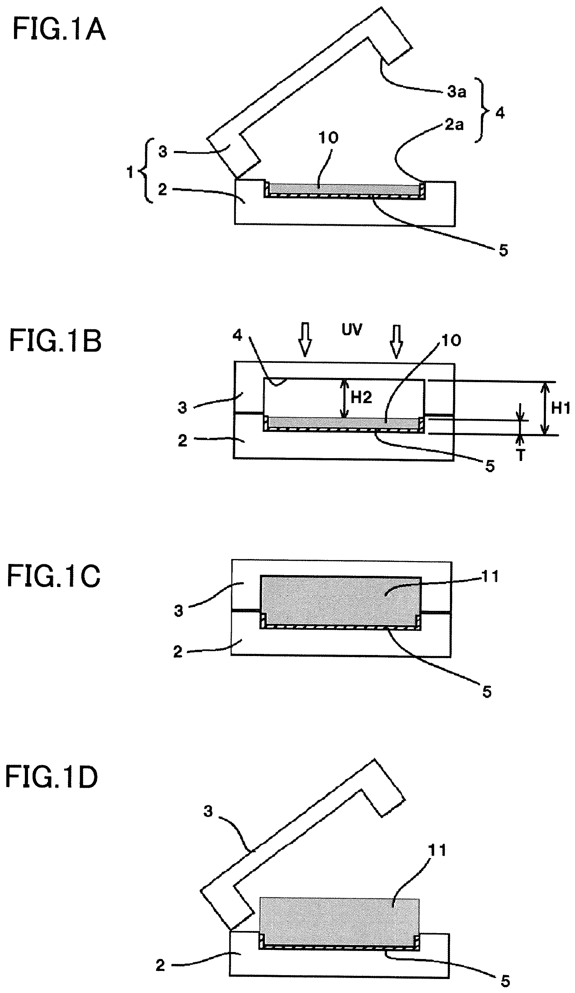

Figs. 1A to 1D illustrate an embodiment of the method of producing the structure of the present disclosure.

A mold 1 for forming the resin foam layer includes a lower mold 2 and an upper mold 3. At least the upper mold 3 is formed of a material that transmits ultraviolet rays. The wavelengths of ultraviolet rays that can be transmitted through the upper mold 3 are, for example, 300 nm or longer and 430 nm or shorter. As illustrated in Fig. 1B, when the lower mold 2 and the upper mold 3 are brought together, a recess 2a of the lower mold 2 and a recess 3a of the upper mold 3 constitute a cavity 4. The upper mold 3 is formed of a transparent resin material having poor affinity with the ultraviolet curable adhesive. For example, the upper mold 3 is formed of an olefin-based resin, such as polypropylene, polyethylene, or the like. Alternatively, a fluororesin film may be formed on an inner surface of the recess 3a of the upper mold 3. Further, an inner surface of the recess 2a of the lower mold 2 also preferably has a configuration having poor affinity with the ultraviolet curable adhesive.

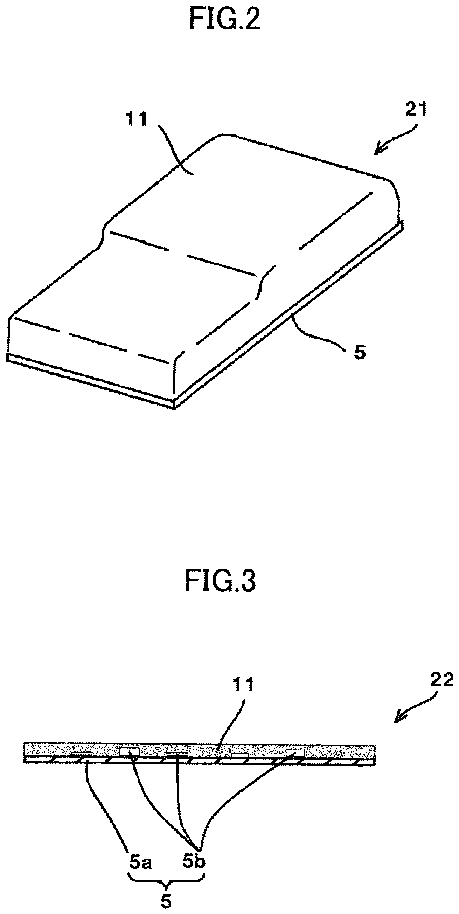

As illustrated in Fig. 1A, when the mold 1 is open, a substrate 5 and a mixture 10 including an ultraviolet curable adhesive are disposed in the recess 2a of the lower mold 2. The mixture 10 is a liquid mixture in which the ultraviolet curable adhesive is not yet cured. The substrate 5 to which the mixture 10 has been applied in advance is disposed in the recess 2a. Alternatively, the substrate 5 is disposed in the recess 2a, and then the mixture 10 including the ultraviolet curable adhesive may be applied to the substrate 5. The substrate 5 is selected according to the intended use of a structure after production. In the case where the structure after production is used as the interior component 21 for an automobile illustrated in Fig. 2, the substrate 5 is a metal, such as iron or the like. In the case where the structure after production is used as the electronic device 22 illustrated in Fig. 3, the substrate 5 is a printed circuit board on which one or more electronic components are mounted.

As illustrated in Fig. 1B, in the state in which the mold 1 is closed, the internal height H1 of the cavity 4 is sufficiently greater than the thickness T including both the substrate 5 and the mixture 10, and a molding space of the height H2 is formed above the surface (liquid surface) of the mixture 10 inside the cavity 4. The height H2 is 0.1 mm or greater, and preferably 0.2 mm or greater. The upper limit of the height H2 varies depending on a product to be produced. The upper limit of the height H2 is, for example, 50 mm, and preferably approximately 25 mm.

The mixture (liquid mixture) 10 includes an ultraviolet curable adhesive and thermally expandable microspheres as a blowing agent. The thermally expandable microspheres are in the shape of particles, and large number of the thermally expandable microspheres are dispersed and included in the ultraviolet curable adhesive. The ultraviolet curable adhesive includes a photopolymerization initiator and an adhesive resin component, and may further include various additives. As the adhesive resin component, an acrylic adhesive resin component (e.g., various acrylate monomers) curable by a radical polymerization reaction or an epoxy-based adhesive resin component curable by a cationic polymerization reaction can be used. The heat generated in the ultraviolet curable adhesive by the polymerization reaction of the adhesive resin component is used for thermal expansion of the thermally expandable microspheres. Since the amount of the heat generated by the polymerization reaction is affected by reactivity of a monomer for use, a type of a photo radical polymerization initiator, and a blending ratio of constituent substances, the ultraviolet curable adhesive is preferably configured by optimally selecting the above conditions.

Each thermally expandable microsphere includes a shell formed of a thermoplastic polymer and a thermal expansion agent, such as liquid hydrocarbon, encapsulated in the shell. As the thermally expandable microspheres, for example, "Matsumoto Microsphere^{®}" manufactured by Matsumoto Yushi-Seiyaku Co., Ltd. can be used. The thermally expandable microspheres have a particle size of approximately 5 µm to 50 µm. When the thermally expandable microspheres are heated, the shells are softened, and the liquid hydrocarbon inside the shells is transformed into a gas, which increases the internal pressure of the shells, thereby expanding the shells. The expansion of the thermally expandable microspheres alone increases the volume by 50 times to 100 times.

In the mold clamping state illustrated in Fig. 1B, ultraviolet rays (UV) are applied to the cavity via the upper mold 3. A UV LED is used as a light source of the UV irradiation. As wavelengths of the UV irradiation, for example, wavelengths of 365 nm to 405 nm are used. As the mixture 10 is irradiated with UV, the adhesive resin component of the ultraviolet curable adhesive in the mixture 10 starts to polymerize to cure the ultraviolet curable adhesive, and the mixture 10 is internally heated by the heat generated by the polymerization reaction of the adhesive resin component. This internal heat facilitates expansion of the thermally expandable microspheres, thereby transforming the mixture 10 into a resin foam layer. In the case where the adhesive resin component is an acrylic adhesive resin component, the photopolymerization initiator is decomposed by UV irradiation to generate radicals, and the generated radicals act on the acrylate monomers or oligomers to initiate polymerization. The shells of the thermally expandable microspheres are softened by the internal heat generated by the radical polymerization, and the liquid hydrocarbon inside the shells is expanded and vaporized so that the mixture 10 is transformed into the resin foam layer 11 as illustrated in Fig. 1C.

When the mixture 10 is applied to the substrate 5, the ultraviolet curable adhesive has affinity with the substrate 5, such as a metal or the like. Since the mixture 10 is adhered to the substrate 5 when the mixture 10 is applied to the substrate 5, the adhesive strength between the resin foam layer 11 and the substrate 5 is maintained even after the adhesive resin component is polymerized and the thermally expandable microspheres are expanded. In the course of foaming, the mixture 10 is brought into contact with the inner surface of the recess 2a of the lower mold 2, which is not covered by the substrate 5, and the inner surface of the recess 3a of the upper mold 3, but the mixture 10 in the process of foaming does not exhibit a strong adhesive force to the inner surfaces of the recess 2a and the recess 3a that will be in contact with a foamed mixture 10. In addition, the lower mold 2 and the upper mold 3 are formed of a material having poor affinity with the adhesive resin component, such as an olefin-based resin or the like. Therefore, when the mold 1 is open, the resin foam layer 11 is easily separated from the upper mold 3, and the outer shape of the resin foam layer 11 created by the molding can be maintained, as illustrated in Fig. 1D.

Fig. 2 illustrates an interior component 21 of an automobile as an example of the structure, which includes the resin foam layer, produced by the above-described method. In the interior component 21, the substrate 5 is a metal plate. The volumetric expansion ratio at the transformation from the mixture 10 including ultraviolet curable adhesive to the resin foam layer 11 is 500% or greater, and preferably 900% or greater, at which the resin foam layer 11 can function as a cushion layer. The resin foam layer 11 is formed into a three-dimensional shape having a smooth curved surface matching the shape of the cavity of the mold 1. Fig. 3 illustrates an electronic device 22 as an example of the structure, which includes the resin foam layer, produced by the above-described method. The substrate 5 of the electronic device 22 includes a printed circuit board 5a on which electronic components 5b constituting an electronic circuit are mounted. The resin foam layer 11 functions as a cover layer covering the electronic components 5b. The volumetric expansion ratio at the transformation from the mixture 10 including the ultraviolet curable adhesive to the resin foam layer 11 as the cover layer is preferably approximately 105% or greater and 130% or less, and is, for example, 110%. When the volumetric expansion ratio is set relatively low, the resin foam layer 11 has the strength suitable as the cover layer, and has elasticity, and therefore the stress applied from the cover layer to each electronic component 5b is reduced.

The volumetric expansion ratio at the transformation from the mixture 10 to the resin foam layer 11 can be adjusted by varying an amount of the microspheres added to the ultraviolet curable adhesive in the mixture 10. In order to adjust the volumetric expansion ratio to 500% or greater for the resin foam layer 11 serving as the cushion layer of the interior component 21 illustrated in Fig. 2, the thermally expandable microspheres are preferably added in the amount of 15 parts by mass or greater and 20 parts by mass or less relative to 100 parts by mass of the ultraviolet curable adhesive. In order to adjust the volumetric expansion ratio to 900% or greater for the resin foam layer 11 serving as the interior component 21, the thermally expandable microspheres are preferably added in the amount of 25 parts by mass or greater relative to 100 parts by mass of the ultraviolet curable adhesive. In order to adjust the volumetric expansion ratio of the resin foam layer 11 to approximately 105% or greater and 130% or less for the resin foam layer 11 serving as the cover layer used in the electronic device 22 illustrated in Fig. 3, the thermally expandable microspheres are preferably added in the amount of 0.05 parts by mass or greater and 0.5 parts by mass or less relative to 100 parts by mass of the ultraviolet curable adhesive. However, the amount of the thermally expandable microspheres added is preferably not greater than 50 parts by mass relative to 100 parts by mass of the ultraviolet curable adhesive, because the adhesive force of the resin foam layer 11 to the substrate 5 decreases. For preparation of the mixture 10, the amount of the thermally expandable microspheres is preferably 0.05 parts by mass or greater and 50 parts by mass or less, and more preferably 0.1 parts by mass or greater and 50 parts by mass or less, relative to 100 parts by mass of the ultraviolet curable adhesive.

When a recommended integral dose of ultraviolet rays is applied to the mixture 10, the adhesive resin component of the ultraviolet curable adhesive in the mixture 10 is polymerized by the energy of the ultraviolet rays, and the ultraviolet curable adhesive is cured from the liquid surface of the ultraviolet curable adhesive to a certain depth. In the present specification, the depth at which the polymerization of the adhesive resin component is progressed and the ultraviolet curable adhesive is cured when ultraviolet irradiation is performed at a recommended integral dose is referred to as a "curing depth," and the index representing different curing depths depending on adhesives is referred to as "deep curability." For example, the ultraviolet curable adhesive A2 listed in Table 1 in Examples below has the deep curability (i.e., the curing depth) of 5.5 mm, when ultraviolet rays are applied at 3,000 (mJ/cm²), which is a recommended integral dose. In addition, the ultraviolet curable adhesive B1 listed in Table 2 has the deep curability (i.e., the curing depth) of 1.7 mm, when ultraviolet rays are applied at 4,500 (mJ/cm²), which is a recommended integral dose. It can be assumed that the above difference in the deep curability is caused by the difference in properties or an amount of the photopolymerization initiator included in the ultraviolet curable adhesive, the difference in properties of monomers or oligomers used as the adhesive resin component, or the like.

Next, the relationship between the difference in the deep curability and thermal expansion of the thermally expandable microspheres will be examined. In the case where the mixture 10 including the ultraviolet curable adhesive having a large (deep) curing depth listed in Table 1 of Examples below is used, the thermally expandable microspheres expand within an extremely short period, such as 3 seconds to 10 seconds, to form a resin foam layer, when a recommended integral dose of ultraviolet rays is applied. On the other hand, in the case where the mixture 10 including the ultraviolet curable adhesive having a small (shallow) curing depth listed in Table 2 is used, the thermally expandable microspheres do not expand even when a recommended integral dose of ultraviolet rays is applied, or even if the thermally expandable microspheres expand, it takes a long time to expand. The reason for this is assumed to be because the ultraviolet curable adhesive having the large (deep) curing depth as exemplified by the ultraviolet curable adhesive A2 is capable of internally generating a large amount of heat through the polymerization reaction of the adhesive resin component, and as a result, the polymerization reaction is progressed from the liquid surface to the deep portion of the ultraviolet curable adhesive within a short period. It is considered that, as the ultraviolet curable adhesive having the large (deep) curing depth is capable of generating a large amount of heat, the thermally expandable microspheres can expand within a short period. On the other hand, it is assumed that the ultraviolet curable adhesive having the small (shallow) curing depth, as exemplified by the ultraviolet curable adhesive B1, internally generates a small amount of heat from the polymerization reaction of the adhesive resin component, even though the integral dose is as large as 4,500 mJ/cm², and the large UV energy is applied to the ultraviolet curable adhesive, and as a result, the polymerization can be progressed only from the liquid surface to the shallow portion of the ultraviolet ray curable resin. It is assumed that the ultraviolet curable adhesive having the small (shallow) curing depth cannot provide a sufficient amount of heat for the thermally expandable microspheres to expand.

In the present disclosure, it is preferable to use the ultraviolet curable adhesive having the curing depth of greater than 5 mm when a recommended integral dose of ultraviolet rays is applied. Further, use of the ultraviolet curable adhesive having the curing depth of 5.1 mm or greater and 10.5 mm or less is preferable. Moreover, the UV light intensity used to reach a recommended integral dose is preferably 500 mW/cm² or greater, and more preferably 1,000 mW/cm² or greater. Even in the case where the ultraviolet curable adhesive having the curing depth of 5 mm or less at a recommended integral dose is used, it is possible to facilitate generation of the heat inside the ultraviolet curable adhesive, and expand the thermally expandable microspheres in the mixture to form a resin foam layer through optimization of UV irradiation conditions, such as increase in the UV light intensity (a unit of mW/cm²), increase in the integral dose (a unit of mJ/cm²), or both. In addition, the present disclosure also includes an embodiment in which the mixture 10 is supplementarily externally heated, and expansion of the thermally expandable microspheres is performed using the heat generated inside the ultraviolet curable adhesive by the polymerization of the adhesive resin component, and the supplementary external heat.

### Examples

The foaming function of the mixture including the ultraviolet curable adhesive and the thermally expandable microspheres will be described hereinafter. The ultraviolet curable adhesives A1, A2, A3, and A4 listed in Table 1 have the curing depth of 5.1 mm or greater and 10.5 mm or less. The ultraviolet curable adhesive B1, B2, and B3 listed in Table 2 have the curing depth of 1.7 mm or greater and 5.0 mm or less.

**Table 1**

| UV adhesive | A1 | A2 | A3 | A4 |
|---|---|---|---|---|
| Integral dose (mJ/cm²) | 5,000 | 3,000 | 10,000 | 7,000 |
| Curing depth after UV irradiation (mm) | 5.1 | 5.5 | 6.0 | 10.5 |

The ultraviolet curable adhesive A1 is a model number "5343" from the 5300 series of Kyoritsu Chemical & Co., Ltd., and includes a modified acrylate monomer as a main component. The ultraviolet curable adhesives A2, A3, and A4 are all UV adhesives manufactured by CHEMITECH INC., and the model numbers of the ultraviolet curable adhesives A2, A3, and A4 are "U2193C," "U2202," and "U2193B," respectively. All of the ultraviolet curable adhesives A2, A3, and A4 include a modified acrylate monomer as a main component.

**Table 2**

| UV adhesive | B1 | B2 | B3 |
|---|---|---|---|
| Integral dose (mJ/cm² ) | 4,500 | 30,000 | 10,000 |
| Curing depth after UV irradiation (mm) | 1.7 | 3.5 | 5.0 |

The ultraviolet curable adhesive B1 is "XVL-14L" from the XVL series of Kyoritsu Chemical & Co., Ltd., the ultraviolet curable adhesive B2 is a UV adhesive "LOCTITE AA 8671 PSA AD" of Henkel Japan Ltd., and the ultraviolet curable adhesive B3 is "AU589V" of Bostik. All of the ultraviolet curable adhesives B1, B2, and B3 include a modified acrylate monomer as a main ingredient.

Examples 1 to 4 are presented in Table 3. Examples 1 to 4 were mixtures, in which the ultraviolet curable adhesives A1 to A4, respectively, and thermally expandable microspheres were mixed. The result obtained by applying ultraviolet rays to the mixture of corresponding Example at the intensity of 1,000 (mW/cm²) to achieve the integral dose presented in Table is presented. In each of Examples 1 to 4, the coating thickness of the mixture was set to 5.0 mm that was smaller than the corresponding curing depth. As the thermally expandable microspheres, "Matsumoto Microsphere F-35" of Matsumoto Yushi-Seiyaku Co., Ltd. was used.

**Table 3**

| | Deep curability (mm) | Ex. 1 | Ex. 2 | Ex. 3 | Ex. 4 |
|---|---|---|---|---|---|
| Adhesive A1 | 5.1 | 100 | NA | NA | NA |
| Adhesive A2 | 5.5 | NA | 100 | NA | NA |
| Adhesive A3 | 6.0 | NA | NA | 100 | NA |
| Adhesive A4 | 10.5 | NA | NA | NA | 100 |
| Micro spheres (mass parts) | | 0.1 | 25 | 40 | 50 |
| UV irradiation (1,000 mW/cm²) | | Performed | Performed | Performed | Performed |
| UV irradiation time (sec) | | 5 | 3 | 10 | 7 |
| Heating | | Not performed | Not performed | Not performed | Not performed |
| Volumetric expansion rate | | 110% | 90% | 1,100% | 1,200% |
| Adhesive strength with substrate after expansion | | Good | Good | Good | Good |

In each of Examples 1 to 4 presented in Table 3, a mixture including 0.1 parts by mass to 50 parts by mass of the thermally expandable microspheres relative to 100 parts by mass of the ultraviolet curable adhesive including the modified acrylate monomer as a main component and having the curing depth of 5.1 mm to 10.5 mm was used, and ultraviolet rays were applied to the mixture at 1,000 (mW/cm²). As a result, the resin foam layer was obtained at the volumetric expansion ratio of 110% for 5 seconds of the UV irradiation time in Example 1. In Example 2, the resin foam layer was obtained at the volumetric expansion ratio of 900% for 3 seconds of the UV irradiation time. In Example 3, the resin foam layer was obtained at the volumetric expansion ratio of 1,100% for 10 seconds of the UV irradiation time. In Example 4, the resin foam layer was obtained at the volumetric expansion ratio of 1,200% for 7 seconds of the UV irradiation time. In all of Examples 1 to 4, the resin foam layer could be obtained within a short period, i.e., the UV irradiation time of 10 seconds or shorter, without using external heat. The resin foam layer resulted from Example 1 is suitably used as a cover layer covering the electronic components 5b in the electronic device 22 illustrated in Fig. 3. The resin foam layers resulted from Examples 2 to 4 are suitably used as a cushion layer in the interior component 21 illustrated in Fig. 2.

Table 4 presents the results obtained by applying ultraviolet rays to the mixtures of Comparative Examples 1 to 3, in which the ultraviolet curable adhesives B1 to B3, respectively, and thermally expandable microspheres were mixed, at the intensity of 1,000 (mW/cm²) to achieve the integral dose presented in Table 2. Note that the mixture was not externally heated. In each of Comparative Examples 1 to 3, the coating thickness of the mixture was set to 5.0 mm.

**Table 4**

| | Deep curability (mm) | Comp . Ex . 1 | Comp. Ex. 2 | Comp. Ex. 3 |
|---|---|---|---|---|
| Adhesive B1 | 1.7 | 100 | NA | NA |
| Adhesive B2 | 3.5 | NA | 100 | NA |
| Adhesive B3 | 5.0 | NA | NA | 100 |
| Micro spheres (mass parts) | | 0.1 | 25 | 40 |
| UV irradiation (1,000 mW/cm²) | | Performed | Performed | Performed |
| Heating | | Not performed | Not performed | Not performed |
| UV irradiation time (sec) | | 4.5 | 30 | 10 |
| volumetric expansion rate | | 0% | 0% | 0% |

In Table 5, the mixtures in which the same ultraviolet curable adhesives B1 to B3 as Comparative Examples 1 to 3, respectively, and thermally expandable microspheres were mixed at the same blending ratios as in Table 4 were used. Comparative Example 4 used the same mixture as Comparative Example 1, Comparative Example 5 used the same mixture as Comparative Example 2, and the Comparative Example 6 used the same mixture as Comparative Example 3. However, in Comparative Examples 4 to 6, after applying ultraviolet rays at the intensity of 1,000 (mW/cm²) for the same time as in Comparative Examples 1 to 3, the mixture was externally heated at 100°C for 10 minutes.

**Table 5**

| | Deep curability (mm) | Comp. Ex . 1 | Comp. Ex. 2 | Comp. Ex. 3 |
|---|---|---|---|---|
| Adhesive B1 | 1.7 | 100 | NA | NA |
| Adhesive B2 | 3.5 | NA | 100 | NA |
| Adhesive B3 | 5.0 | NA | NA | 100 |
| Micro spheres (mass parts) | | 0.1 | 25 | 40 |
| UV irradiation (1,000 mW/cm²) | | Performed | Performed | Performed |
| UV irradiation time (sec) | | 4.5 | 30 | 10 |
| Heating | | 100°C | 100°C | 100°C |
| Heating time after UV irradiation (sec) | | 600 | 600 | 600 |
| Volumetric expansion rate | | 1,100% | 1,100% | 1,100% |

According to Comparative Examples 1 to 3 presented in Table 4, in the case where the ultraviolet curable adhesive having the curing depth of 1.7 mm to 5.0 mm was used, even though the recommended dose of ultraviolet rays was applied, the amount of the heat generated in the ultraviolet curable adhesive was not sufficient, and as a result most of the thermally expandable microspheres did not expand. According to Comparative Examples 4 to 6 presented in Table 5, even in the case where the ultraviolet curable adhesive having the curing depth of 1.7 mm to 5.0 mm was used, the thermally expandable microsphere could be expanded by externally heating the mixture at approximately 100°C in addition to the UV irradiation.

In the present disclosure, as in Examples 1 to 4 of Table 3, when an ultraviolet curable adhesive including an acrylic resin as a main component and having a curing depth of 5.1 mm to 10.5 mm is used, a resin foam layer can be formed within a short period of 10 seconds or shorter by performing only UV irradiation, which is a preferable embodiment. Even in the case where an ultraviolet curable adhesive having a curing depth of 1.7 mm to 5.0 mm is used, as in Comparative Examples 4 to 6 of Table 5, the thermally expandable microspheres can be expanded by externally heating the mixture at approximately 100°C in addition to the UV irradiation, although it takes approximately 10 minutes. Accordingly, the present disclosure also includes an embodiment in which heating is performed in addition to UV irradiation, as in Comparative Examples 4 to 6.

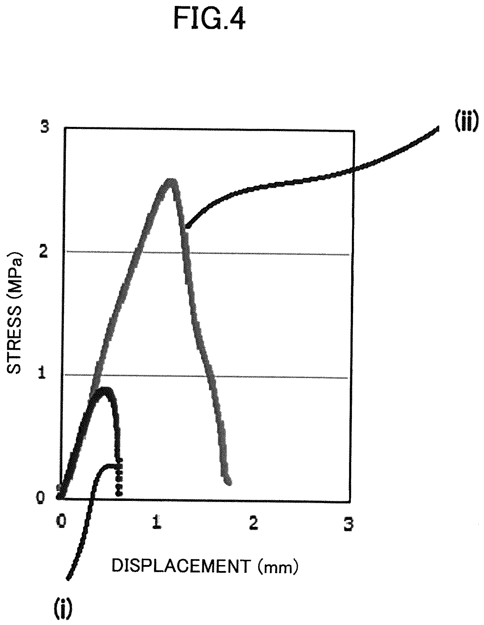

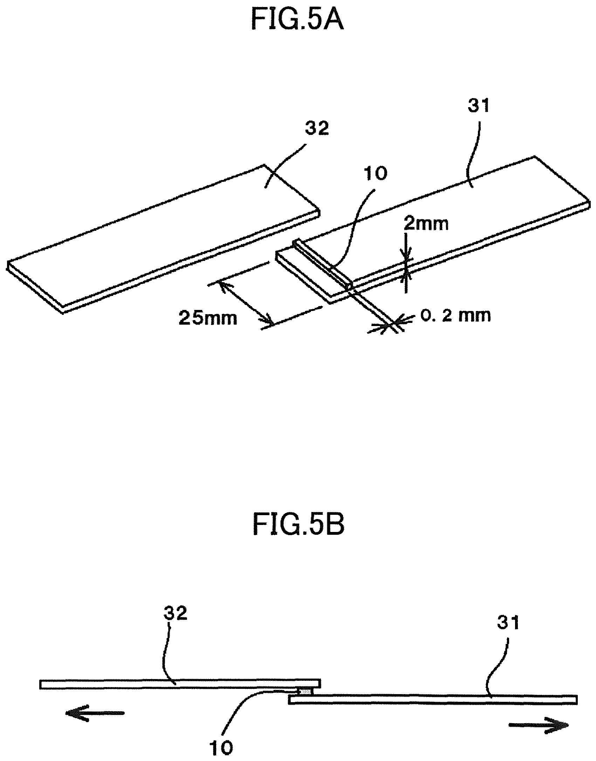

Fig. 4 and Figs. 5A and 5B depict the evaluation of the adhesive force of the mixture including the ultraviolet curable adhesive and the thermally expandable microspheres with respect to the substrate. In the adhesive force measuring test illustrated in Figs. 5A and 5B, the mixture 10 was applied to opposing surfaces of two polycarbonate resin plates 31 and 32 in Fig. 5A, and the two polycarbonate resin plates 31 and 32 were bonded in Fig. 5B. The mixture is the same as Example 1 of Table 3. The mixture was applied to have a width of 2 mm, a thickness of 0.2 mm, and a length of 25 mm. In the graph of Fig. 4, the horizontal axis represents a displacement (mm) when the polycarbonate resin plates 31 and 32 are pulled in the planar direction, and the vertical axis represents the shear stress (MPa) acting on the mixture 10 at corresponding displacement. In the graph of Fig. 4, (i) represents a change in shear stress when the mixture 10 was heated at 100°C in advance in the state in which the polycarbonate resin plates were bonded as illustrated in Fig. 5B, ultraviolet rays were applied at 1,000 (mW/cm²) for 5 seconds to expand the microspheres, followed by pulling the polycarbonate resin plates 31 and 32 in the planar direction. In Fig. 4, (ii) represents a change in shear stress when ultraviolet rays were applied in the state in which the polycarbonate resin plates were bonded as illustrated in Fig. 5B at 1, 000 (mW/cm²) for 5 seconds in advance, heating was performed at 100°C for 10 minutes to expand the thermally expandable microspheres, followed by pulling the polycarbonate resin plates 31 and 32 in the planar direction.

It was found that when the mixture was applied to the substrate 5, and then UV irradiation was performed to form the resin foam layer as represented by (ii) of Fig. 4, the maximum shear stress (shear fracture strength) was large, and the resin foam layer had the sufficient adhesive strength to the substrate 5. It was found that the maximum shear stress (shear fracture strength) was reduced when the mixture 10 was externally heated to foam before the UV irradiation, as represented by (i) of Fig. 4. It was found from Fig. 4 and Figs. 5A and 5B that the high adhesive strength between the resin foam layer and the substrate was maintained when the adhesive resin component included in the mixture 10 was cured by ultraviolet rays. Accordingly, in the case where heating is supplementarily performed in addition to UV irradiation, the adhesive strength to the substrate can be maintained by performing the UV irradiation first, followed by heating.

Although the method of producing the structure has been described with reference to the above embodiments, the present disclosure is not limited to the above embodiments, and various variations and modifications may be made without departing from the scope of the claims.

## Claims

1. A method of producing a structure including a substrate and a resin foam layer bonded to the substrate, the method comprising:
coating the substrate with a mixture including an ultraviolet curable adhesive and thermally expandable microspheres, the ultraviolet curable adhesive including a photopolymerization initiator and an adhesive resin component; and
irradiating the mixture with ultraviolet rays to polymerize the adhesive resin component and expand the thermally expandable microspheres, thereby forming the resin foam layer,
wherein the resin foam layer is bonded to the substrate with an adhesive force of the adhesive resin component.

2. The method of producing the structure according to claim 1,
wherein the coating includes coating of the substrate with the mixture at a thickness equal to or less than a curing depth of the ultraviolet curable adhesive when a recommended integral dose of ultraviolet energy is applied.

3. The method of producing the structure according to claim 2,
wherein the curing depth is greater than 5 mm.

4. The method of producing the structure according to claim 3,
wherein the curing depth is 5.1 mm or greater and 10.5 mm or less.

5. The method of producing the structure according to one of claims 1 to 4,
wherein the mixture includes the thermally expandable microspheres in an amount of 50 parts by mass or less relative to 100 parts by mass of the ultraviolet curable adhesive.

6. The method of producing the structure according to claim 5,
wherein the mixture includes the thermally expandable microspheres in an amount of 0.1 parts by mass or greater and 50 parts by mass or less relative to 100 parts by mass of the ultraviolet curable adhesive.

7. The method of producing the structure according to one of claims 1 to 6,
wherein the coating includes accommodating of the substrate and the mixture in a cavity of a mold, the cavity having an internal height greater than a total thickness of the substrate and the mixture, and
the irradiating includes irradiating of the mixture with ultraviolet rays passing through the mold.

8. A method of producing an interior component, the method comprising:
forming a cushion layer with the resin foam layer using the method of producing the structure according to one of claims 1 to 7.

9. A method of producing an electronic device, the method comprising:
using a printed circuit board on which an electronic component is mounted as a substrate, and forming a cover layer covering the electronic component with the resin foam layer using the method of producing the structure according to one of claims 1 to 7.
